## Europäisches Patentamt
## European Patent Office
## Office européen des brevets

(19)

(11) Numéro de publication: **0 1 1 5 9 7 0**
**B1**

(12) **FASCICULE DE BREVET EUROPEEN**

(45) Date de publication du fascicule du brevet:
**01.06.88**

(51) Int. Cl.⁴: **H 01 J 37/32, C 23 F 1/00**

(21) Numéro de dépôt: **84400002.6**

(22) Date de dépôt: **03.01.84**

(54) **Enceinte pour le traitement et notamment la gravure de substrats par la méthode du plasma réactif.**

(30) Priorité: **05.01.83 FR 8300073**

(43) Date de publication de la demande:
**15.08.84 Bulletin 84/33**

(45) Mention de la délivrance du brevet:
**01.06.88 Bulletin 88/22**

(84) Etats contractants désignés:
**CH DE GB IT LI NL**

(56) Documents cités:
**FR - A - 2 397 067**
**US - A - 4 030 967**

**CHEMICAL ABSTRACTS, vol.97, no.8, août 1982, page 242, no.59757h, Columbus, Ohio, US**

(73) Titulaire: **COMMISSARIAT A L'ENERGIE ATOMIQUE, 31/33, rue de la Fédération, F-75015 Paris (FR)**

(72) Inventeur: **Laporte, Philippe, 11, Allée Jean Philippe Rameau, F-38130 Echirolles (FR)**
Inventeur: **Peccoud, Louise, Rue des Martyrs, F-38640 Claix (FR)**

(74) Mandataire: **Mongrédien, André et al, c/o BREVATOME 25, rue de Ponthieu, F-75008 Paris (FR)**

## Description

La présente invention a pour objet une enceinte destinée au traitement et notamment à la gravure sous plasma actif.

L'invention trouve une application dans le dépôt de couches de nature quelconque (isolantes, conductrices, semi-conductrices) sur des substrats quelconques (métalliques, semi-conducteurs, isolants), par exemple dans le dépôt d'isolant sur des substrats de silicium, opération fondamentale dans la fabrication des semiconducteurs.

Elle trouve surtout une application privilégiée dans la gravure d'un substrat si le gaz introduit est approprié à cette fonction.

On sait que le procédé de dépôt de couche sous décharge luminescente est particulièrement intéressant lorsqu'on désire éviter au substrat une élévation importante de température. Il est connu en effet que les méthodes ordinaires de dépôt chimique en phase vapeur nécessitent une température élevée, par exemple d'au moins 350 °C pour $SiO_2$ et 600 °C pour $Si_3N_4$. Ces méthodes sont donc exclues pour certains substrats comme, par exemple, HgCdTe ou AsGa ou ZnTe, qui ne supportent pas de telles températures. La technique du dépôt sous décharge luminescente, qui permet de réaliser des dépôts à une température proche de l'ambiante, offre donc un réel avantage.

Le procédé de dépôt réactif sous décharge luminescente consiste essentiellement à provoquer un plasma dans un mélange réactif introduit dans une enceinte où sont disposés les substrats à recouvrir. L'un des effets du plasma est de rompre certaines liaisons moléculaires des espèces gazeuses en présence et d'initier des réactions chimiques. Les substrats répartis sur une sole placée au voisinage du plasma se recouvrent alors d'une couche dont la composition dépend du mélange gazeux utilisé.

On pourra consulter à propos de cette technique, par exemple le brevet américain US-A-3 757 733 ou encore l'article intitulé «A Production Reactor for Low Temperature Plasma-enhanced Silicon Nitride Deposition», publié par R.S. Rosler et al dans la revue «Solid State Technology», volume 19, no 6, 1976, page 45 et les articles qui y sont cités.

De telles enceintes perfectionnées pour traiter des substrats par la méthode du plasma réactif ont été décrites antérieurement également dans la demande de brevet FR-A-2 397 067 et comportent essentiellement des moyens pour uniformiser la répartition du gaz réactif qui, après avoir traversé l'électrode d'introduction, atteint le substrat à traiter.

L'attaque d'un substrat sous plasma réactif joue un rôle de plus en plus important dans la technologie des circuits intégrés pour fabriquer des films comprenant du silicium, des composés du silicium (silice, siliciure, nitrure de silicium) ainsi que l'aluminium et ses composés (aluminium-silicium, aluminium-silicium-cuivre). D'autres composés semiconducteurs tels que l'arséniure de gallium, l'antimoniure d'indium et le phosphure d'indium relèvent également de cette technique connue.

Le procédé d'attaque par plasma réactif consiste à introduire un gaz réactif à basse pression dans l'enceinte de gravure contenant le substrat à graver et à soumettre ce gaz à une décharge électrique froide (température voisine de la température ambiante) qui dissocie le gaz en espèces diffusantes actives, c'est-à-dire ions et radicaux libres qui vont alors réagir sur le substrat et éventuellement l'attaquer. On a malheureusement remarqué que la nature physique et chimique du matériau qui constitue l'enceinte de réaction elle-même joue un rôle très important sur la cinétique et les performances de la gravure ou du dépôt réalisé.

En effet, le plasma n'est pas absolument confiné entre les deux électrodes, mais du fait des conditions de pression et de la nature du gaz réactif, il peut diffuser jusqu'aux parois mêmes du réacteur. La dissociation et/ou la recombinaison des espèces diffusantes actives sur les parois de l'enceinte est variable selon la réactivité chimique de ces parois et on a observé des formations importantes de polymères lorsque lesdites parois de l'enceinte sont en acier inoxydable; dans ce dernier cas, on parvient ainsi à une cinétique de réaction différente entraînant une diminution notable des vitesses de gravures, une perte de sélectivité des gravures d'un matériau par rapport à une autre, une modification des profils de ces mêmes gravures, de même la nature chimique des parois change le potentiel plasma modifie le raport $\dfrac{[\text{ions}]}{[\text{neutres}]}$.

Pour lutter contre ces difficultés, on a tenté d'utiliser des parois a priori plus inertes, comme par exemple le quartz qui a été employé avec succès pour ralentir la formation des polymères précédents dans les enceintes de gravures sous plasma réactif. Malheureusement, l'utilisation de quartz pour constituer lesdites parois entraîne un coût très élevé de l'installation, une fragilité mécanique accrue car le quartz est plus fragile que les métaux et enfin le risque d'introduction d'une pression partielle d'oxygène dans l'enceinte au cours de son fonctionnement. En effet, les radicaux actifs qui migrent vers les parois attaquent le quartz et peuvent, dans certains cas, libérer de l'oxygène dans l'enceinte, ce qui nuit considérablement à la cinétique des réactions de gravures ainsi qu'à la qualité des gravures ou des dépôts obtenus.

La présente invention a précisément pour objet une enceinte pour le traitement de substrats par la méthode de plasma réactif qui pallie, par des moyens particulièrement simples, les difficultés de l'art antérieur rappelé précédemment.

Cette enceinte métallique pour le traitement et notamment la gravure de substrats par la méthode du plasma réactif, comprenant une entrée et une sortie pour la circulation d'un gaz réactif à basse pression, une sole supportant le substrat à traiter placée entre deux électrodes dont l'une est au potentiel de la mase, et l'autre ou électrode de radiofréquence, est portée à un potentiel alternatif relativement à celui de la masse de façon à créer dans l'enceinte une décharge électrique qui dissocie le gaz en espèces réactives qui réagissent sur le substrat, ladite enceinte étant recouverte intérieurement par projection au calumeau à plasma d'une couche protectrice d'alumine $Al_2O_3$, est caractérisée en ce que le revêtement d'alumine $Al_2O_3$ a une épaisseur comprise entre 300 µm et 500 µm et est complété par une imprégnation de silicone.

Selon l'invention, l'enceinte de réaction est réalisée dans un métal ou un alliage tel que par exemple l'aluminium ou l'acier inoxydable et recouverte par schoopage ou projection au chalumeau à plasma d'un revêtement protecteur complété par une imprégnation de silicone sur toute sa paroi intérieure. Le matériau de revêtement est utilisé sous forme d'une poudre de granulométrie choisie que l'on projette dans le chalumeau à plasma de façon que le matériau utilisé atteigne la fusion dans la flamme et se trouve projeté à l'état fondu sur la paroi interne de l'enceinte de réaction où il vient alors former un dépôt adhérent. De façon préférentielle l'imprégnation de silicone est obtenue sous pression et en température.

Selon une caractéristique secondaire mais importante de la présente invention, l'électrode de radiofréquence de l'enceinte est également recouverte d'un matériau protecteur qui peut être dans certains cas de l'alumine $Al_2O_3$ mais de préférence du tungstène, notamment lorsque la réaction de gravure a lieu dans un milieu de trifluorométhane $CHF_3$.

Une application originale de la présente invention est d'améliorer l'anisotropie de gravure du silicium polycristallin pendant la gravure avec $SF_6$. En effet, un réacteur inox recouvert d'un dépôt d'$Al_2O_3$ shoopé produit une gravure de silicium par $SF_6$ anisotrope, alors que dans les mêmes conditions un réacteur non revêtu donne une gravure de silicium isotrope.

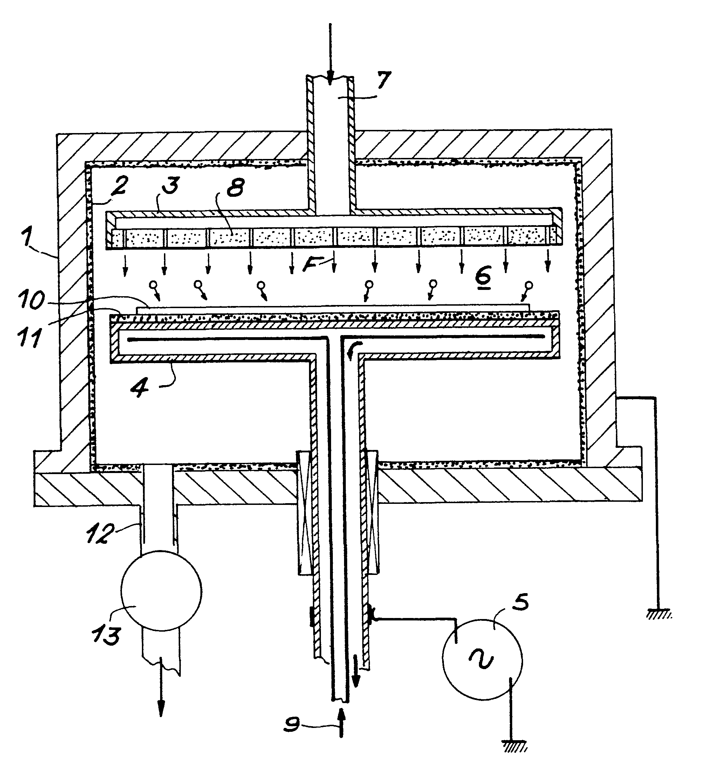

De toute façon, l'invention sera mieux comprise en se rapportant à la lecture qui suit d'un exemple de mise en œuvre donné à titre illustratif et non limitatif, qui sera décrit en se référant à la figure unique jointe montrant en coupe élévation une enceinte conforme à la présente invention.

Sur la figure unique, on a représenté l'enceinte 1 pour la gravure du substrat qui est réalisée en acier inoxydable ou en aluminium et revêtue intérieurement par schoopage d'un revêtement 2 d'Alumine $Al_2O_3$ d'une épaisseur voisine de 300 µm et complété par une imprégnation de silicone. Cette enceinte comporte, de façon connue, deux électrodes dont l'une supérieure 3 est à la masse et l'autre inférieure 4 est portée à un potentiel alternatif par un alternateur 5 de façon à créer en 6 dans l'espace compris entre les électrodes 3 et 4, une décharge électrique ou plasma. L'électrode supérieure 3 qui est fixe et creuse est reliée à une canalisation 7 d'introduction du gaz réactif à basse pression, lequel est distribué dans l'espace entre les électrodes 3 et 4 au travers d'une paroi poreuse 8 qui rend homogène le flux de gaz dans cette zone, comme représenté par les différentes flèches F.

Une canalisation 12 équipée d'une pompe 13 permet d'assurer la circulation et l'extraction dans l'enceinte 1 du gaz réactif introduit par la canalisation 7.

L'électrode de radiofréquence inférieure 4 est mobile autour de son axe et comporte un circuit de fluide de refroidissement 9. Elle sert dans l'exemple décrit de sole supportant le substrat 10 à graver qui est ainsi directement exposé au flux de gaz réactif sortant de la paroi poreuse 8. Le plasma réalisé dans l'espace 6 dissocie le gaz réactif en espèces diffusantes actives, c'est-à-dire en ions et en radicaux libres qui viennent réagir directement sur le substrat 10 à graver.

Dans l'exemple particulier décrit, l'électrode de radiofréquence 4 est également protégée par un revêtement 11 obtenu par shoopage pour améliorer les qualités de la gravure et éviter les phénomènes de pulvérisation.

L'enceinte décrite sur la figure précédente a été utilisée avec un revêtement en $Al_2O_3$ sur un réacteur en acier inoxydable pour faire des gravures de substrat de $SiO_2$ en milieu de trifluorométhane $CHF_3$ avec toute satisfaction, alors que dans des conditions identiques et en l'absence du revêtement d'$Al_2O_3$, les réactions de polymérisation qui se développaient sur la surface interne de l'enceine annihilaient complètement la phase de gravure recherchée.

Parallèlement au progrès technique apporté par ce revêtement 2 de la paroi interne, le recouvrement de l'électrode de radiofréquence par un matériau tel que le tungstène, qui reste inerte en présence d'un bombardement ionique dans une ambiance de $CHF_3$, a permis d'améliorer la sélectivité de gravures $SiO_2/Si$ d'un facteur 2 par comparaison avec une électrode de radiofréquence simplement revêtue d'$Al_2O_3$. A ce sujet, on rappellera que la sélectivité de gravure d'un corps par rapport à un autre se définit par le rapport des vitesses des gravures de chacun de ces corps.

On notera enfin que le revêtement 2 d'$Al_2O_3$ possède des propriétés intéressantes, notamment du fait qu'il est facile à nettoyer et qu'il est exempt de toute porosité.

Bien entendu, l'alumine et le tungstène décrits pour le revêtement de l'électrode de radiofréquence ne sont pas donnés à titre limitatif; tout autre matériau ou alliage approprié peut également être utilisé à volonté selon les buts recherchés sans pour autant sortir du cadre de l'invention.

**Revendications**

1. Enceinte métallique pour le traitement et notamment la gravure de substrats par la méthode du plasma réactif, comprenant une entrée (7) et une sortie (12) pour la circulation d'un gaz réactif à basse pression, une sole supportant le substrat (10) à traiter placée entre deux électrodes dont l'une (3) est au potentiel de la masse, et l'autre (4) ou électrode de radiofréquence, est portée à un potentiel alternatif relativement à celui de la masse de façon à créer dans l'enceinte une décharge électrique qui dissocie le gaz en espèces réactives qui réagissent sur le substrat, ladite enceinte étant recouverte intérieurement par projection au chalumeau à plasma d'une couche protectrice (2) d'alumine Al$_2$O$_3$, caractérisée en ce que le revêtement d'alumine Al$_2$O$_3$ a une épaisseur comprise entre 300 µm et 500 µm et est complété par une imprégnation de silicone.

2. Enceinte selon la revendication 1, caractérisée en ce que l'électrode de radiofréquence (4) est également recouverte d'un matériau protecteur.

3. Enceinte selon la revendication 2, caractérisée en ce que le matériau protecteur recouvrant l'électrode de radiofréquence est l'alumine Al$_2$O$_3$.

4. Enceinte selon la revendication 2, caractérisée en ce que le matériau protecteur recouvrant l'électrode de radiofréquence est le tungstène.

## Claims

1. Metal enclosure for the treatment and particularly for the etching of substrates by the reactive plasma method, including an inlet (7) and an outlet (12) for the circulation of a reactive gas at low pressure, a base supporting the substrate (10) to be treated placed between two electrodes, of which one (3) is at earth potential and the other (4) or radio frequency electrode is brought to an alternating potential in relation to that of the earth, so as to create in the enclosure an electrical discharge which dissociates the gas into reactive species which react with the substrate, the said enclosure being lined by plasma torch spraying with a protective layer (2) of alumina Al$_2$O$_3$, characterized in that the coating of alumina Al$_2$O$_3$ has a thickness of between 300 µm and 500 µm and is completed by an impregnation with silicone.

2. Enclosure according to Claim 1, characterized in that the radio frequency electrode (4) is also covered with a protective material.

3. Enclosure according to Claim 2, characterized in that the protective material covering the radio frequency electrode is alumina Al$_2$O$_3$.

4. Enclosure according to Claim 2, characterized in that the protective material covering the radio frequency electrode is tungsten.

## Patentansprüche

1. Metallgefäss für die Bearbeitung, insbesondere Ätzung von Substraten durch das Verfahren des reaktiven Plasmas, mit einem Einlass (7) und einem Auslass (12) für die Durchströmung eines reaktiven Gases niederen Drucks, einem das zu bearbeitende Substrat (10) tragenden Boden, der zwischen zwei Elektroden angeordnet ist, von denen die eine (3) auf Massepotential und die andere (4) oder Hochfrequenzelektrode auf einem Wechselpotential in Bezug auf dasjenige der Masse derartig gelegt ist, dass in dem Behälter eine elektrische Entladung erzeugt wird, die das Gas in reaktive Arten dissoziiert, die auf das Substrat wirken, wobei der Behälter im Inneren durch Plasmabrennerspritzen mit einer Schutzschicht (2) aus Aluminiumoxid Al$_2$O$_3$ überdeckt ist, dadurch gekennzeichnet, dass die Überdeckung aus Aluminiumoxid Al$_2$O$_3$ eine Dicke zwischen 300 µm und 500 µm aufweist und durch eine Silikonimpregnation vervollständigt ist.

2. Gefäss nach Anspruch 1, dadurch gekennzeichnet, dass die Hochfrequenzelektrode (4) ebenfalls mit einem Schutzmaterial überdeckt ist.

3. Gefäss nach Anspruch 2, dadurch gekennzeichnet, dass das die Hochfrequenzelektrode überdeckende Schutzmaterial Aluminiumoxid Al$_2$O$_3$ ist.

4. Gefäss nach Anspruch 2, dadurch gekennzeichnet, dass das die Hochfrequenzelektrode überdeckende Schutzmaterial Wolfram ist.